# EUROPEAN PATENT SPECIFICATION

(11) **EP 2 400 567 B1**
(45) Date of publication and mention of the grant of the patent: **08.03.2017**
(21) Application number: 11169327.1
(22) Date of filing: 09.06.2011
(51) Int. Cl.: H01L 33/50

(54) **Phosphor selection for a Light-Emitting Device**
Phosphorauswahl für eine Licht-emittierende Vorrichtung
Sélection de phosphores pour un dispositif électroluminescent

(30) Priority: 25.06.2010 JP 2010144504
(43) Date of publication of application: 28.12.2011
(73) Proprietor: Panasonic Intellectual Property Management Co., Ltd., Osaka-shi, Osaka 540-6207 (JP)
(72) Inventor: Kuzuhara, Ikko, Toyonaka, Osaka (JP); Nishioka, Kouji, Kadoma, Osaka (JP)
(74) Representative: Rüger, Barthelt & Abel

(56) References cited:
- EP-A1- 2 104 149
- JP-A- 2009 224 074
- JP-A- 2009 231 569
- US-A1- 2005 211 991

## Description

### [Field of the Invention]

The present invention relates to a light-emitting element and a light-emitting device using phosphors that convert a wavelength of light exiting from this light-emitting element.

### [Background Art]

A light-emitting diode (LED) can emit light with lower power and high luminance, and is used as a light source in various electrical devices such as a display and an illumination fixture. In recent years, in addition to a red LED and a green LED, a blue LED has been put into practice, and the LEDs of these three RGB colors can be combined together or the LED and phosphors converting a wavelength of light exiting from the LED can be combined together to thereby emit light of various colors.

Also known is a light-emitting device which outputs yellow light by providing light of a blue LED to phosphors and mixes blue light and the yellow light to thereby create white light. In a light-emitting device of this type emitting white light, for example, YAG-based phosphors are dispersed in a resin material such as silicone resin for sealing the blue LED, and the YAG-based phosphors convert a wavelength of the blue light exiting from the LED to emit the yellow light.

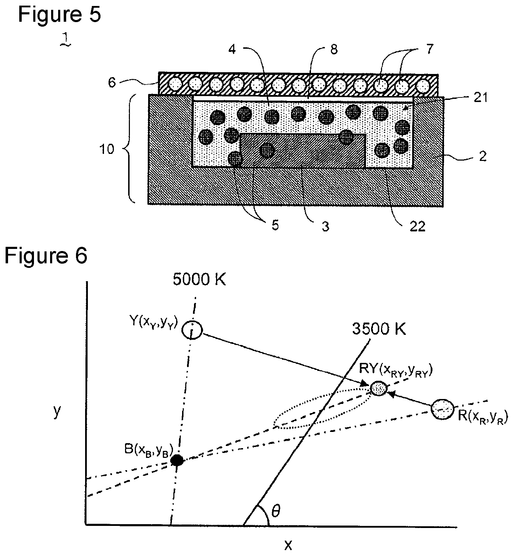

However, in the case where the blue light and the yellow light are mixed to provide the white light, variation in a wavelength of emitted light and a half-value width of a peak wavelength and variation in, for example, concentration of the phosphors contained in the resin material due to manufacturing tolerance of the blue LED, etc. results in variation in chromaticity coordinates of the mixed light in different directions among different manufactured products. For example, as shown in Fig. 6, "chromaticity coordinates Y "(x_{Y}, y_{Y})" of yellow phosphors and chromaticity coordinates "R (x_{R}, y_{R})" of red phosphors are combined together to create a phosphor layer with chromaticity coordinates RY (X_{RY}, Y_{RY}). Then an attempt is made to combine this phosphor layer and a blue LED chip with chromaticity coordinates B "X_{B}, Y_{B})" to provide a color temperature of 3500K. In this case, an isotempearutre line set at 5000K of white color by the blue LED chip and the yellow phosphors and an isotemperature line (with an angle of θ) with 3500K do not become parallel to each other, thus causing variation in the color temperature.

Thus, in recent years, a plurality of light-emitting devices using an LED, for example, as is the case with a light source for an illumination fixture, are combined together in many cases, which therefore requires minimizing variation in color temperature among different manufactured products.

Known as a conventional technique that controls the variation is a white light-emitting device (for example, see Patent literature 1) which controls variation in color temperature by ranking a blue LED to be used in accordance with a wavelength and luminance of emitted light and then adjusting luminance of the light emitted by phosphors so as to correspond to the ranked LED. Here, the blue LED and the phosphors are appropriately combined together so that chromaticity coordinates of light emitted by the blue LED and chromaticity coordinates of the light emitted by the phosphors are plotted on an isotemperature line with a predetermined color temperature. As a result, for the mixed light, variation in chromaticity coordinates occurs along on the isotemperature line. The isotemperature line is a straight line plotting chromaticity coordinates with the same color temperature on a chromaticity diagram, and variation in chromaticity coordinates along the isotemperature line results in small variation in the color temperature itself.

Also known is an LED light source (for example, see Patent literature 2) further provided with a color temperature adjusting member containing phosphors (second phosphors) emitting light of a color different from that of phosphors (first phosphors) emitting yellow light. In this LED light source, even under the presence of variation in, for example, wavelength of light emitted by the LED and concentration of the first phosphors, use of the second phosphors makes it possible to arbitrarily set chromaticity coordinates of final light exiting from the color temperature adjusting member.

### [Conventional Technique Literature]

[Patent Literature 1] Japanese Patent No. 4201167
[Patent Literature 2] JP 2009-231569A

EP2104149 discloses the features of the pre-amble of the independent claim.

JP2009224074 discloses a method of reducing the variation in color temperature in a light-emitting device.

### [Disclosure of the Invention]

### [Problems to be solved by the Invention]

However, techniques disclosed in these Patent literatures permit improvement in variation with a single color and color temperature adjustment, but still have difficulty in bringing a color temperature line with 5000K of white provided by the blue LED chip and the yellow phosphors to be parallel to an isotemperature line with 3500K (angle θ), thus posing a problem that a desired color temperature cannot be achieved.

In view of the problem described above, the present invention has been made, and it is an object of the present invention to provide a light-emitting device having small variation in color temperature of light mixed by using a light-emitting element such as an LED and phosphors that are excited by light exiting from the light-emitting element to emit light.

### [Means adapted to solve the Problems]

To solve the problem described above, a light-emitting device according to the present invention includes: a light-emitting element; first phosphors excited by light emitted by the light-emitting element to emit light; and second phosphors excited by the light emitted by the light-emitting element or the light emitted by the first phosphors to emit light. Inclination of a straight line on a chromaticity diagram linking chromaticity coordinates of the light emitted by the first phosphors and chromaticity coordinates of the light emitted by the light-emitting element is adapted to be equal to inclination of an isotemperature line with a predetermined color temperature of light obtained by mixing the light emitted by the light-emitting element, the light emitted by the first phosphors, and the light emitted by the second phosphors.

Preferably, chromaticity coordinates of the light emitted by the second phosphors have an x value located on a side higher than the straight line on the chromaticity diagram linking the chromaticity coordinates of the light emitted by the light-emitting element and the chromaticity coordinates of the light emitted by the first phosphors.

Preferably, the first phosphors or the second phosphors are adapted to have a combination of a plurality of kinds of phosphor particles to emit light with desired chromaticity coordinates.

A sealing member of resin sealing the light-emitting element is further provided, and the first phosphors are dispersed in a resin material forming the sealing member.

A coating member provided in a light take-out direction of the sealing member is further provided, and the second phosphors are dispersed in a resin material or glass forming the coating member.

A gap is formed between the sealing member and the coating member.

### [Effect of the Invention]

Variation in color coordinates of light obtained by mixing light emitted by a light-emitting element, light emitted by first phosphors, and light emitted by second phosphors occurs along on an isotemperature line, thus providing the light-emitting device with small variation in color temperature.

### [Brief Description of the Drawings]

[Fig. 1] Fig. 1 is a side sectional view of a light-emitting device according to one embodiment of the present invention.
[Fig. 2] Fig. 2 is a partially exploded perspective view of the same light-emitting device.
[Fig. 3] Fig. 3 is a schematic chromaticity diagram illustrating adjustment of chromaticity coordinates and color temperature of light emitted by the same light-emitting device.
[Fig. 4] Fig. 4 is a chromaticity diagram in an example of the same light-emitting device.
[Fig. 5] Fig. 5 is a side sectional view of a light-emitting device according to a modified example of the embodiment.
[Fig. 6] Fig. 6 is a schematic chromaticity diagram illustrating a reason why variation in color temperature occurs in a conventional light-emitting device.

### [Best Mode for Carrying Out the Invention]

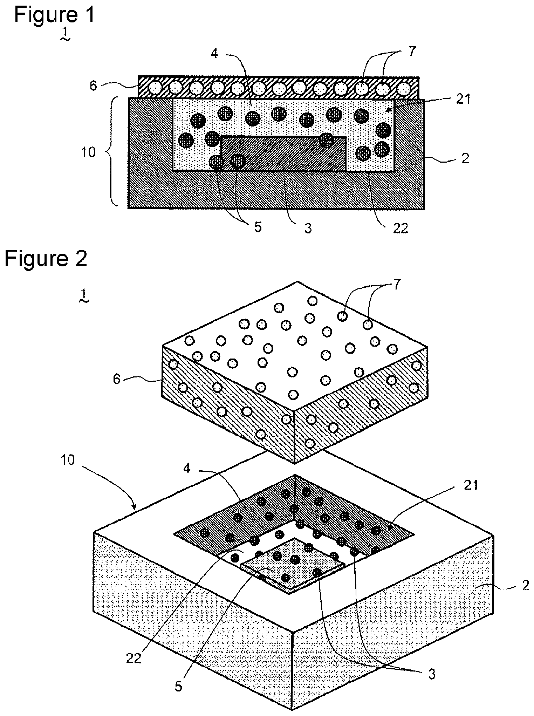

A light emitting-device according to one embodiment of the present invention will be described, referring to Figs. 1 to 4. The light-emitting device 1 of this embodiment is provided with: as shown in Figs. 1 and 2, a substrate 2 formed with a depressed portion 21; and a light-emitting element 3 mounted at the depressed portion 21 of the substrate 2. Into the depressed portion 21, a sealing member 4 of resin is filled, and to the resin forming this sealing member 4, first phosphors 5 that are excited by light emitted by the light-emitting element 3 to emit light are dispersed. A package made by mounting the light-emitting element 3 at the depressed portion 21 of the substrate 2 and filling the sealing member 4 including the first phosphors 5 into the depressed portion 21 is called an LED package 10. The LED package 10 has a coating member 6 provided in a light take-out direction of the sealing member 4, and to a resin material or glass forming this coating member 6, second phosphors 7 which are excited by the light emitted by the light-emitting element 3 or the light emitting by the first phosphors 5 to emit light are dispersed.

The substrate 2 is a substrate for a general-use light-emitting module, and is formed of metal oxide (including ceramic) or metal nitride such as aluminum oxide (Al₂O₃) or aluminum nitride (AIN) having electric insulation properties, or a material such as metal, resin, or glass fiber. The depressed portion 21 is formed into a square shape at a substantially central part on a top surface of the substrate 2, and has its bottom surface serving as a mounting surface 22 on which the light-emitting element 3 is mounted. Note that a shape of the depressed portion 21 is not limited to the square shown in the figure and may be of a conic shape or a multi-sided pyramid. Moreover, as long as the mounting surface 22 is coated with an insulation layer, the concave part 21 may be, for example, coated with a metal material having high optical reflectance.

Provided on the mounting surface 22 is a wiring patter (not shown) formed of conductive metal such as gold (Au) or silver (Ag), and this wiring pattern is electrically connected to the light-emitting element 3 and an external power terminal part. Alternatively, by forming a via hole in the substrate 2 and inserting a wiring of conductive metal or the like through this via hole, a wiring pattern (not shown) may be provided not on the front surface of the substrate 2 but on a rear surface of the substrate 2. These wiring patterns excluding terminal parts are coated with an insulation layer.

The light-emitting element 3 is not specifically limited as long as it is a light source that permits emission of light of a desired color as the light-emitting device 1, but a CaN-based blue LED chip that radiates blue light is preferably used. In this embodiment, a chip of a rectangular plate-like shape is shown as the light-emitting element 3, but a shape of the light-emitting element 3 is not limited to this, and thus the one in accordance with, for example, intended purpose of the light-emitting device 1 is used. The light-emitting element 3 has as detailed configuration: a light-emitting part including a laminated structure of a p-type nitride semiconductor layer, a light-emitting layer, and an n-type nitride semiconductor layer; a cathode electrode electrically connected to the n-type nitride semiconductor layer; and an anode electrode electrically connected to the p-type nitride semiconductor layer. The cathode electrode and the anode electrode are formed on a bottom surface side of the element, and these cathode electrode and anode electrode are joined to the element terminal part of the wiring pattern via a bump, whereby the light-emitting element 3 is mounted on the substrate 2. Illustrated here as a method of mounting the light-emitting element 3 is an example in which a face-down type light-emitting element 3 is mounted with a flip-chip mounted, but the light-emitting element 3 may be a chip of a face-up type, in which case, for example, a method of making connection by use of a dice bond and a wire is used. On a light take-out surface of the light-emitting element 3, for example, a convex lens member for improving light take-out efficiency may be provided.

For the sealing member 4, a translucent resin material such as a silicone resin, an epoxy resin, or a modified epoxy resin having properties of these two is used. This resin material is kneaded with the first phosphors 5 with predetermined concentration and filled through potting in a manner such as to have a predetermined thickness in the depressed portion 21.

Used for the first phosphor 5 is a kind in accordance with light-emitting performance such as a color temperature required of the light-emitting device 1 and a light-emitting characteristic including a wavelength of the light emitted by the light-emitting element 3, and kneaded with the resin material in a manner such as to have predetermined concentration. In the case where a GaN-based blue LED is used as the light-emitting element 3, preferably used for the first phosphor 5 is a well-known yellow phosphor which is excited by absorbing part of blue light exiting from the light-emitting element 3 and which has a peak wavelength in a wavelength range of 500 to 650 nm. This yellow phosphor has a peak wavelength of emitted light in a yellow wavelength range and has a wavelength range of the emitted light including a red wavelength range. Listed as the yellow phosphor is a so-called YAG-based phosphor including crystals with Garnet composition of complex oxide of Yttrium and Aluminum, although not necessarily limited thereto. The first phosphor 5 may be a combination of a plurality of kinds of phosphor particles.

Used for the coating member 6 is, for example, a member obtained by kneading phosphors with a translucent resin material such as a silicone resin, an epoxy resin, or an acryl resin and forming this phosphor-containing resin material into a sheet-like shape by use of a mold. The coating member 6 may be formed by applying the resin material described above onto the light-emitting element 3 through an application method, for example, printing, an inkjet method, or potting. In the resin material, a filler or the like may be contained for the purpose of promoting mixed coloring of colors of different light and also improving heat conductivity. Moreover, glass may be used for the coating member 6. In this case, for example, phosphor-dispersed glass can be produced by mixing together powdery glass and phosphor particles, placing these mixed powders on a framed flat plate, and subjecting them to melt-solidification at reduced-pressure high-temperature atmosphere.

Also used for the second phosphor 7 is, as is the case with the first phosphor 5, the one of a kind in accordance with the light-emitting performance such as the color temperature that is required of the light-emitting device 1 and the light-emitting characteristic such as wavelengths of the light emitted by the light-emitting element 3 and the first phosphor 5 is used, and kneaded with a resin material or a glass material in such a manner as to have predetermined concentration. In the case where a GaN-based blue LED is used as the light-emitting element 3 and an yellow phosphor is used as the first phosphor 5, preferably used for the second phosphors 7 is a well-known orange or red phosphor which is excited by absorbing part of the light emitted by the light-emitting element 3 and the first phosphors 5 and which has a peak wavelength in a wavelength range of 600 to 750 nm. Listed as an example of this phosphor are SCASN phosphor particles. The second phosphors 7 may also be a combination of a plurality of kinds of phosphor particles.

In the light-emitting device 1, the light emitted by the light-emitting element 3 first excites the first phosphors 5 dispersed in the sealing member 4, and in response to this excitation, the first phosphors 5 emit light. The light emitted by the light-emitting element 3 and the light emitted by the first phosphors 5 enter the coating member 6 and excite the second phosphors 7 dispersed in the coating member 6, and in response to this excitation, the first phosphors 5 emit light. The light emitted by the light-emitting element 3, the light emitted by the first phosphors 5, and the light emitted by the second phosphors 7 are mixed together in the coating member 6 and exit from a light take-out surface of the coating member 6.

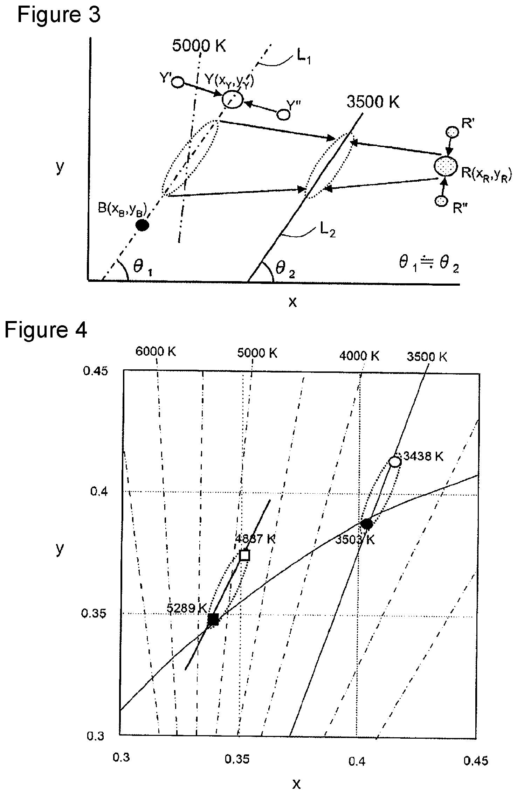

Here, a process of adjusting chromaticity coordinates and the color temperature of the light emitted by the light-emitting device 1 will be described, referring to Fig. 3. The light-emitting device 1 mixes together the light emitted by the light-emitting element 3, the emitted by the first phosphors 5, and the light emitted by the second phosphors 7 so that inclination θ1 of a straight line on a chromaticity diagram linking chromaticity coordinates Y (x_{Y}, y_{Y}) of the light emitted by the first phosphors 5 and chromaticity coordinates B (x_{B}, y_{B}) of the light emitted by the light-emitting element 3 becomes equal to inclination θ2 of an isotemperature line L₂ of light with a predetermined color temperature. The predetermined color temperature here is a color temperature desired for the light emitted by the light-emitting device 1 and is 3500K in this embodiment. Moreover, chromaticity coordinates of the light emitted by the second phosphors 7 are R (x_{R}, y_{R}).

First, a process of adjusting the LED package 10 will be described. First, the chromaticity coordinates of the light emitted by the light-emitting element 3 are measured and its coordinates are plotted on the chromaticity diagram. Then based on the plotted coordinates, a straight line with inclination of an isotemperature line with a color temperature of 3500K is drawn, and a kind, concentration, a mixing ratio, etc. of the first phosphors 5 are determined so that the chromaticity coordinates of the light emitted by the first phosphors 5 are arranged on this straight line. Variation in the chromaticity coordinates of the light emitted by the light-emitting element 3 is attributable to manufacturing tolerance of an LED chip, and thus it is difficult to adjust this upon manufacture of the light-emitting device 1. On the other hand, for the first phosphors 5, the kind, the concentration, the mixing ratio, etc. of the phosphors can be accurately selected and measured and they can be added to the resin material forming the sealing member 4, and thus it is relatively easy to accurately adjust the chromaticity coordinates of the light emitted by the first phosphors 5. This permits bringing the inclination of the straight line on the chromaticity diagram linking the chromaticity coordinates of the light emitted by the first phosphors 5 and the chromaticity coordinates of the light emitted by the light-emitting element 3 to be equal to the inclination of the isotemperature line with a color temperature of 3500K.

The adjusted LED package 10, when the light emitted by the first phosphors 5 and the light emitted by the light-emitting element 3 are mixed together, causes variation in chromaticity coordinates of light along the straight line L₁ with the inclination θ1 the same as the inclinationθ2 of the isotemperature line L₂ with a finally desired color temperature. As a result, the variation in the chromaticity coordinates in the LED package 10 occurs along the straight line L₁, resulting in large variation in the color temperature.

Next, a process of adjusting the light-emitting device 1 having the coating member 6, in which the second phosphors 7 are dispersed, provided on the light take-out surface of the sealing member 4 of the LED package 10 will be described. For the second phosphor 7, as is the case with the first phosphor 5, a kind, concentration, a mixing ratio, etc. of the phosphor can accurately be selected and measured. Moreover, its thickness, form, etc. can be controlled upon machining for formation of the coating member 6, and thus the chromaticity coordinates of the light emitted by the second phosphors 7 can more accurately be adjusted than those of the first phosphors 5.

Here, when the light emitted by the second phosphors 7 is combined, if the amount of this light is equal to the amount of the light emitted by the first phosphors 5 and the light-emitting element 3, variation in the chromaticity coordinates occurs in a manner such as to "shift" towards the chromaticity coordinates R (x_{R}, y_{R}) of the second phosphors 7 while maintaining the inclination θ1 of the straight line L₁, and a range of this variation substantially agree with the isotemperature line L₂ with the color temperature. That is, as a result of combining the light emitted by the second phosphors 7, the variation in the chromaticity coordinates of the light emitted by the light-emitting device 1 occurs along on the isotemperature line L₂, thus resulting in small variation in the color temperature. Consequently, the light-emitting device 1 with small variation in the color temperature can be provided.

Moreover, in this embodiment, the chromaticity coordinates R of the light emitted by the second phosphors 7 has an x value located on a side higher than the straight line L₁ on the chromaticity diagram linking the chromaticity coordinates B of the light emitted by the light-emitting element 3 and the chromaticity coordinates Y of the light emitted by the first phosphors 5, that is, located on a right side in the chromaticity diagram. That is, the light-emitting element 3 and the first phosphors 5 are combined together to emit light with a high color temperature, and then the second phosphors 7 are combined to shift a color temperature of the mixed light to a low color temperature. As a result of this, in a high color temperature range (left side of the chromaticity diagram), the color temperature varying along on the straight line L₁ can be shifted to a low color temperature range (right side of the chromaticity diagram) and brought into agreement with the isotemperature line L₂ with a predetermined color temperature, thus reducing the variation in the color temperature.

The first phosphor 5 may independently emit light with desired chromaticity coordinates Y (x_{Y}, y_{Y}), or as shown in the figure, a plurality of kinds (two in this example) of phosphors emitting light with different chromaticity coordinates (for example, Y', Y") may be combined together to make adjustment so that light with desired chromaticity coordinates Y (x_{Y}, y_{Y}) is emitted. The second phosphors 7 may also independently emit light with desired chromaticity coordinates R (x_{R}, y_{R}'), or a plurality of kinds (two in this example) of phosphors emitting light with different chromaticity coordinates (for example, R', R) may be combined together. The second phosphors 7 in this embodiment shift the variation in the chromaticity coordinates of the light emitted by the LED package 10 to the isotemperature line L₂ of the light with the final color temperature. For example, third phosphors (not shown) for including a process of shifting to another chromaticity coordinates during this shift may be included in either of the LED package 10 and the coating member 6.

Next, referring to Fig. 4, more detailed manufacturing processes, including, for example, adjusting the chromaticity coordinates and the color temperature of the light emitted by the light-emitting device 1, in the example of the light-emitting device 1 will be described. Also in this example, a color temperature required of the light exiting from the light-emitting device 1 is 3500K.

Used for the light-emitting element 3 is a blue LED of a square shape one-mm in diameter and approximately 100 pm in thickness, as a GaN-based semiconductor emitting blue light with a peak wavelength of approximately 450 nm. Used for the substrate 2 is a package substrate of aluminum ceramic having a wiring pattern plated with gold (Au). For the sealing member 4, using silicone resin containing 30 wt% of YAG-based phosphor particles as the first phosphors 5, and potting this on the depressed portion 21 of the substrate 2 in such a manner as to provide approximately 100m in thickness to thereby seal the light-emitting element 3. The LED package 10 formed in this manner has a color temperature range of approximately 4800 to 5200K and variation in chromaticity coordinates occurring along on a straight line with the same inclination as that of the isotemperature line with a color temperature of 3500K. This variation is mainly attributable to an amount of first phosphors 5 contained, variation in the dispersion of the first phosphors 5, variation in the amount of silicone resin potted, etc.

Next, the coating member 6 is formed by molding as the second phosphors 7 a sheet-like member which is formed of silicone resin containing 3 wt% of SCASN phosphor particles and which has a thickness of 0.4 mm. This coating member 6 is machined by using a mold and thereby its thickness accuracy can be adjusted in units of several µm, and also the phosphors and the resin can be mixed together and shorten time from when they are injected into the mold to when thermal-curing ends. This results in small variation in dispersion and thickness of the phosphors, which permits small variation in color temperature attributable to the second phosphors 7 included in the coating member 6. As a result, accurate "shift" can be achieved in a manner such that the variation in chromaticity coordinates occurs along on a desired isotemperature line.

The light-emitting device 1 is manufactured by combining the coating member 6 formed in this manner with the LED package 10. The variation in chromaticity coordinates of the light emitted by this light-emitting device 1 occurs along on the isotemperature line with a color temperature of 3500K, with little color temperature variation. This provides the light-emitting device 1 with small color temperature variation. Adaptation may be made such that, upon setting the kind, concentration, etc. of the second phosphors 7, the variation in the chromaticity coordinates of the LED package 10 can be "shifted" towards a long wavelength side along a black locus. This provides the light-emitting device 1 capable of emitting light of a natural color.

Next, a light-emitting device according to a modified example of this embodiment will be described, referring to Fig. 5. The light-emitting device 1 according to this modified example has a gap 8 formed between a sealing member 4 and a coating member 6. Other aspects of configuration are the same as that of the embodiment described above. With this configuration, in the coating member 6, of light emitted by the second phosphors 7, part of the light directed towards an LED package 10 is totally reflected on an interface between the coating member 6 and the gap 8. Thus, the light exits from a light take-out surface of the coating member 6 with high possibility, resulting in improved light usage efficiency. Moreover, the totally reflected light is further mixed in the coating member 6, thus homogenizing color temperature of the light exiting from the light take-out surface of the coating member 6. In the gap 8, a filling material or the like for improving light take-out efficiency and heat radiation may be arranged.

The present invention is not limited to the embodiment described above, and thus various modification can be made to the present invention as long as the inclination θ1 of the straight line L₁ on the chromaticity diagram linking the chromaticity coordinates Y of the light emitted by the first phosphors 5 and the chromaticity coordinates B of the light emitted by the light-emitting element 3 becomes equal to the inclination θ2 of the isotemperature line L₂ of light with a desired color temperature. Moreover, the coating member 6 may be a member including a plurality of resin layers having different phosphors dispersed therein, which are combined together to function in the same manner as the second phosphors 7 of this embodiment. A light converting member (not shown), for example, which contains fourth phosphors, for further converting a wavelength of light emitted by the light-emitting device 1 may be further provided.

### [Description of Reference Numerals]

1 Light-emitting device
3 Light-emitting element
4 Sealing member
5 First phosphors
6 Coating member
7 Second phosphors
8 Gap
B Chromaticity coordinates of light emitted by the light-emitting element
R Chromaticity coordinates of light emitted by the second phosphors
Y Chromaticity coordinates of light emitted by the first phosphors
L₁ Straight line on a chromaticity diagram linking the chromaticity coordinates of the light emitted by the first phosphors and the chromaticity coordinates of the light emitted by the light-emitting element
L₂ Isotemperature line of light with a predetermined color temperature θ₁ Inclination of the straight line
θ₂ Inclination of the isotemperature line

## Claims

1. A light-emitting device comprising: a light-emitting element; first phosphors excited by light emitted by the light-emitting element to emit light; and second phosphors excited by the light emitted by the light-emitting element or the light emitted by the first phosphors to emit light, **characterized in that**
inclination of a straight line on a chromaticity diagram linking chromaticity coordinates of the light emitted by the first phosphors and chromaticity coordinates of the light emitted by the light-emitting element is adapted to be equal to inclination of an isotemperature line with a predetermined color temperature of light obtained by mixing the light emitted by the light-emitting element, the light emitted by the first phosphors, and the light emitted by the second phosphors.

2. The light-emitting device according to claim 1, wherein
chromaticity coordinates of the light emitted by the second phosphors have an x value located on a side higher than the straight line on the chromaticity diagram linking the chromaticity coordinates of the light emitted by the light-emitting element and the chromaticity coordinates of the light emitted by the first phosphors.

3. The light-emitting device according to either claim 1 or 2, wherein the first phosphors or the second phosphors are adapted to have a combination of a plurality of kinds of phosphor particles to emit light with desired chromaticity coordinates.

4. The light-emitting device according to any of claims 1 to 3, further comprising a sealing member of resin sealing the light-emitting element, wherein the first phosphors are dispersed in a resin material forming the sealing member.

5. The light-emitting device according to claim 4, further comprising a coating member provided in a light take-out direction of the sealing member, wherein
the second phosphors are dispersed in a resin material or glass forming the coating member.

6. The light-emitting device according to claim 5, wherein
a gap is formed between the sealing member and the coating member.

## Patentansprüche

1. Lichtemittierende Einrichtung aufweisend: ein lichtemittierendes Element; erste Phosphore, die durch das von dem lichtemittierenden Element emittierten Licht angeregt werden, um Licht zu emittieren; und zweite Phosphore, die durch das Licht, das von dem lichtemittierenden Element emittiert wird oder das Licht, das durch die ersten Phosphore emittiert wird, angeregt werden, um Licht zu emittieren,
**dadurch gekennzeichnet, dass**
die Steigung einer geraden Linie in einer Farbtafel, die die Farbwertkoordinaten des durch die ersten Phosphore emittierten Lichts und die Farbwertkoordinaten des durch das lichtemittierende Element emittierten Lichts verbindet ausgebildet ist, gleich der Steigung von einer Isotemperaturlinie mit einer vorbestimmten Farbtemperatur des Lichts zu sein, die durch Mischen des durch das lichtemittierende Element emittierten Lichts, des durch die ersten Phosphore emittierten Lichts und des durch die zweiten Phosphore emittierten Lichts erhalten wird.

2. Lichtemittierende Einrichtung nach Anspruch 1, wobei die Farbwertkoordinaten des durch die zweiten Phosphore emittierten Lichts einen x-Wert haben, der auf einer Seite angeordnet ist, die größer ist als die gerade Linie in der Farbtafel, die die Farbwertkoordinaten des Lichts, das von dem lichtemittierenden Element emittiert wird und die Farbwertkoordinaten des Lichts, das von den ersten Phosphoren emittiert wird, verbindet.

3. Lichtemittierende Einrichtung nach irgendeinem der Ansprüche 1 oder 2, wobei die ersten Phosphore oder die zweiten Phosphore dazu eingerichtet sind, eine Kombination von einer Mehrzahl von Arten von Phosphorpartikeln aufzuweisen, um Licht mit gewünschten Farbwertkoordinaten zu emittieren.

4. Lichtemittierende Einrichtung nach irgendeinem der Ansprüche 1 bis 3, außerdem aufweisend ein Dichtelement aus Harz, das das lichtemittierende Element abdichtet, wobei die ersten Phosphore in einem Harzmaterial dispergiert sind, das das Dichtelement bildet.

5. Lichtemittierende Einrichtung nach Anspruch 4, außerdem aufweisend ein Beschichtungselement, das in einer Lichtausgaberichtung des Dichtelements vorhanden ist, wobei
die zweiten Phosphore in einem Harzmaterial oder Glas dispergiert sind, das das Beschichtungselement bildet.

6. Lichtemittierende Einrichtung nach Anspruch 5, wobei ein Spalt zwischen dem Dichtungselement und dem Beschichtungselement gebildet ist.

## Revendications

1. Dispositif émetteur de lumière comprenant : un élément émetteur de lumière ; des premières substances luminescentes excitées par la lumière émise par l'élément émetteur de lumière pour émettre de la lumière ; et des deuxièmes substances luminescentes excitées par la lumière émise par l'élément émetteur de lumière ou la lumière émise par les premières substances luminescentes pour émettre de la lumière,
**caractérisé en ce que** l'inclinaison d'une ligne droite sur un diagramme chromatique reliant les coordonnées chromatiques de la lumière émise par les premières substances luminescentes et les coordonnées chromatiques de la lumière émise par l'élément émetteur de lumière est adaptée pour être égale à l'inclinaison d'une ligne isotherme avec une température de couleur de lumière prédéterminée obtenue en mélangeant la lumière émise par l'élément émetteur de lumière, la lumière émise par les premières substances luminescentes et la lumière émise par les deuxièmes substances luminescentes.

2. Dispositif émetteur de lumière selon la revendication 1, dans lequel les coordonnées chromatiques de la lumière émise par les deuxièmes substances luminescentes ont une valeur de x située sur un côté supérieur à la ligne droite sur le diagramme chromatique reliant les coordonnées chromatiques de la lumière émise par l'élément émetteur de lumière et les coordonnées chromatiques de la lumière émise par les premières substances luminescentes.

3. Dispositif émetteur de lumière selon la revendication 1 ou 2, dans lequel les premières substances luminescentes ou les deuxièmes substances luminescentes sont adaptées pour avoir une combinaison d'une pluralité de sortes de particules de substances luminescentes pour émettre de la lumière avec les coordonnées chromatiques souhaitées.

4. Dispositif émetteur de lumière selon l'une quelconque des revendications 1 à 3, comprenant en outre un élément d'étanchéité en résine qui scelle l'élément émetteur de lumière, dans lequel les premières substances luminescentes sont dispersées dans un matériau de type résine formant l'élément d'étanchéité.

5. Dispositif émetteur de lumière selon la revendication 4, comprenant en outre un élément de revêtement placé dans une direction d'extraction de lumière de l'élément d'étanchéité, dans lequel les deuxièmes substances luminescentes sont dispersées dans un matériau de type résine ou dans du verre formant l'élément de revêtement.

6. Dispositif émetteur de lumière selon la revendication 5, dans lequel un espace est formé entre l'élément d'étanchéité et l'élément de revêtement.
